# EUROPÄISCHE PATENTANMELDUNG

(11) **EP 1 130 635 A1**
(43) Veröffentlichungstag der Anmeldung: **05.09.2001**
(21) Anmeldenummer: 01103099.6
(22) Anmeldetag: 09.02.2001
(51) Int. Cl.: H01L 21/316, H01L 21/02, H01L 21/8246

(54) **Herstellungsverfahren für einen Speicherkondensator mit einem Dielektrikum auf der Basis von Strontium-Wismut-Tantalat**

(30) Priorität: 01.03.2000 DE 10009762
(71) Anmelder: Infineon Technologies AG, 81669 München (DE)
(72) Erfinder: Bachhofer, Harald, 81677 München (DE); Hartner, Walter, 81829 München (DE); Schindler, Guenther, Dr., 80802 München (DE); Haneder, Thomas Peter, 81549 München (DE); Hoenlein, Wolfgang, Dr., 82008 Unterhaching (DE)
(74) Vertreter: Barth, Stephan Manuel, Dr.

(57) **Zusammenfassung**

Die Kristallisationstemperatur einer ferroelektrischen Schicht (3) (Dielektrikum) für einen Speicherkondensator kann dadurch abgesenkt werden, daß vor ihrer Abscheidung auf eine erste Platin-Elektrodenschicht (1) des Speicherkondensators eine sehr dünne CeO₂-Schicht (2) aufgebracht wird. Die in amorphem Zustand abgeschiedene Dielektrikumsschicht (3) wird anschließend durch eine Temperaturbehandlung bei einer Temperatur im Bereich zwischen 590°C und 620°C kristallisiert. Anschließend wird eine zweite Elektrodenschicht (4) zur Vervollständigung des Speicherkondensators aufgebracht.

## Beschreibung

Die Erfindung betrifft ein Verfahren zum Herstellen eines Speicherkondensators, beispielsweise eines Halbleiterbauelements, wie einer DRAM- oder FRAM-Speicherzelle.

Die vorliegende Erfindung bezieht sich somit auf das Gebiet der Herstellung von Halbleiter-Speicherbauelementen in der Mikroelektronik.

Aus der DE 198 40 824 C1 ist ein Herstellungsverfahren für einen ferroelektrischen Transistor bekannt, bei dem auf einer 5-10 nm dicken CeO₂-Schicht eine ferroelektrische Schicht mit einem CVD-Prozessor aufgebracht wird und bei 700°C getempert wird, um sie in die gewünscht ferrolektrische Phase zu bringen.

Die DE 198 29 300 A1 offenbart eine ferroelektrische Speichereinrichtung mit einer elektrischen Verbindung zwischen einer unteren Kondensatorelektrode und einem Kontaktstopfen sowie ein entsprechendes Herstellungsverfahren.

Die EP 088 631 782 offenbart eine di-elektrische Speichervorrichtung mit einem ferroelektrischen Dielektrikum.

Die US-A-5,955,755 offenbart eine Halbleiterspeichervorrichtung und ein entsprechendes Herstellungsverfahren, wobei ein Siliciumoxydfilm, ein orientierter Paraelektrischer Oxidfilm und ein orientierter ferroelektrischer Film auf ein einkristallines Siliciumsubstrat laminiert werden.

Die in der Mikroelektronik hergestellten dynamischen Halbleiterspeicher-Bauelemente (DRAMs oder FRAMs) bestehen im wesentlichen aus einem Auswahl- oder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätskonstante von maximal etwa 8 aufweisen. Zur Verkleinerung des Speicherkondensators sowie zur Herstellung von nicht-flüchtigen Speichern werden "neuartige" Kondensatormaterialien, wie beispielsweise ferroelektrische oder paraelektrische Materialien mit deutlich höheren Dielektrizitätskonstanten, benötigt. Ein paar dieser Materialien sind in der Publikation "Neue Dielektrika für Gbit-Speicherchips" von W. Hönlein, Phys. Bl. 55 (1999), genannt. Zur Herstellung von ferroelektrischen Kondensatoren für Anwendungen in derartigen nicht-flüchtigen Halbleiterspeicher-Bauelementen hoher Integrationsdichte können z.B. ferroelektrische Materialien, wie SrBi₂ (Ta, Nb)₂O₉ (SBT oder SBTN), Pb (Zr, Ti)O₃ (PZT), oder Bi₄Ti₃O₁₂ (BTO) als Dielektrikum zwischen den Kondensatorplatten eingesetzt werden. Es kann aber auch ein paraelektrisches Material, wie beispielsweise (BaSr) TiO₃ (BST), zum Einsatz kommen.

Die Verwendung dieser neuartigen ferroelektrischen oder paraelektrischen Dielektrika stellt jedoch die Halbleiterprozeßtechnologie vor neue Herausforderungen. Zunächst lassen sich diese neuartigen Materialien nämlich nicht mehr mit dem traditionellen Elektrodenmaterial Polysilizium kombinieren. Deshalb müssen inerte Elektrodenmaterialien, wie beispielsweise Platinmetalle, d.h. Pt, Pd, Ir, Rh, Ru oder Os, oder deren leitfähige Oxide (z.B. RuO₂), eingesetzt werden. Es können auch allgemein leitfähige Oxide, wie LaSrCoOx oder SrRuO₃, verwendet werden. Der Grund hierfür liegt darin, daß nach dem Abscheiden des ferroelektrischen Dielektrikums dieses in einer sauerstoffhaltigen Atmosphäre bei Temperaturen von etwa 550 - 800°C gegebenenfalls mehrfach getempert ("konditioniert") werden muß. Zur Vermeidung von unerwünschten chemischen Reaktionen des ferroelektrischen Dielektrikums mit den Elektroden werden diese daher zumeist aus Platin oder einem anderen ausreichend temperaturstabilen und inerten Material, wie einem anderen Platinmetall oder einem leitfähigen Oxid, gefertigt.

In ferroelektrischen Speicherbauelementen wird das aus einer ersten, unteren Elektrode, der ferro- oder paraelektrischen Schicht und einer zweiten, oberen Elektrode bestehende Kondensatormodul entweder als "stacked capacitor" oder als "off-set capacitor" integriert. Bei dem "stacked capacitor"-Konzept wird die untere Elektrode über einen Metallisierungsstopfen ("plug") durch eine Isolationsschicht an das Source- oder Drain-Gebiet des zugeordneten Auswahltransistors angeschlossen. Bei dem "off-set capacitor"-Konzept wird dagegen die obere Elektrode über die erste Metallisierungsebene (über einen Metallbügel) und einen durch zwei Isolationsschichten verlaufenden Metallisierungsstopfen an das Drain-Gebiet des zugeordneten Auswahltransistors angeschlossen.

Das "offset-capacitor"-Konzept ist das technologisch einfachere Konzept, da die elektrische Verbindung nach der Herstellung des Kondensators gefertigt wird und somit nicht die dabei auftretende Temperaturbelastung aushalten muß. Allerdings ist mit dieser Variante der Nachteil eines relativ hohen Flächenverbrauches verbunden, da Transistor und Kondensator nebeneinander angeordnet werden müssen.

Bei dem "stacked-capacitor"-Konzept wird eine geringere Fläche benötigt Bei dieser Variante muß jedoch der Metallstopfen, der eine Elektrode des Kondensators mit Source oder Drain verbindet, alle für den Kondensator notwendigen Annealschritte aushalten, ohne dabei merklich oxidiert zu werden. Wird er so stark oxidiert, daß zwischen Transistor und Kondensator keine leitende Verbindung mehr besteht, führt dies zum Ausfall der Zelle.

Um das Problem der Oxidation zu vermeiden, werden einerseits nede Barrieren entwickelt, die einer hohen Temperaturbelastung von 700°C und darüber in Sauerstoffatmosphäre standhalten. Andererseits wird versucht, die für die Einstellung der gewünschten ferroelektrischen Eigenschaften nötige Temperaturbelastung zu reduzieren, z.B. durch gezielte Einstellung einer bestimmten Stöchiometrie der ferroelektrischen Schicht.

Um auf Platin abgeschiedenes SrBi₂Ta₂O₉ (SBT) in der ferroelektrischen Aurivillius-Phase zu kristallisieren, sind bei 180 nm dicken SBT-Schichten Temperaturen von ca. 680°C erforderlich. Bei dieser Temperatur ist es bereits sehr schwierig, den Kontakt zwischen Kondensator und Transistor so auszuführen, daß er während einer durchschnittlich einstündigen Temperung der ferroelektrischen Schicht in 02 nicht oxidiert wird. Deshalb wird nach Möglichkeiten gesucht, die Prozeßtemperatur bei gleichbleibender Qualität der ferroelektrischen Schicht zu senken.

Der Erfindung liegt demnach die Aufgabe zugrunde, eine Schichtstruktur mit einer ferroelektrischen Schicht und ein Verfahren zu ihrer Herstellung und ein Herstellungsverfahren für einen Speicherkondensator mit einer ferroelektrischen Schicht als Dielektrikum anzugeben, bei welchen die in den Herstellungsschritten, insbesondere bei der Temperung oder Konditionierung der ferroelektrischen Schicht, verwendeten Temperaturen bei gleichbleibender Qualität der ferroelektrischen Schicht erniedrigt werden können.

Diese Aufgabe wird durch die Merkmale des Gegenstandes des Anspruchs 1 gelöst.

Die SBT- oder SBTN-Schicht wird also im wesentlichen als amorphe Schicht abgeschieden und nach der Abscheidung wird eine Temperaturbehandlung durchgeführt, bei der die amorphe Schicht kristallisiert.

Im Rahmen einer Untersuchung der Kristallisationstemperatur von SrBi₂Ta₂O₉ (SBT) auf CeO₂ für die Herstellung ferroelektrischer Transistoren wurde gefunden, daß SBT auf CeO₂ bereits bei ca. 590°C-620°C beginnt, die ferroelektrische Aurivillius-Phase auszubilden. Die Prozeßtemperatur für die Kristallisation kann also im Vergleich zu direkt auf Platin abgeschiedenem SBT um ca. 60°C-90°C abgesenkt werden.

Das erfindungsgemäße Verfahren kann dazu verwendet werden, einen Speicherkondensator herzustellen, wobei als Substrat eine erste Elektrodenschicht bereitgestellt wird, auf der ersten Elektrodenschicht eine sehr dünne CeO₂-Schicht abgeschieden wird, auf die CeO₂-Schicht dann die SBT-Schicht aufgebracht und durch den Temperaturbehandlungsschritt rekristallisiert wird und schließlich auf die SBT-Schicht eine zweite Elektrodenschicht abgeschieden wird.

Die Elektrodenschichten können aus einem Platinmetall, insbesondere Platin, einem leitfähigen Oxid eines Platinmetalls oder einem anderen leitfähigen und inerten Oxid hergestellt werden.

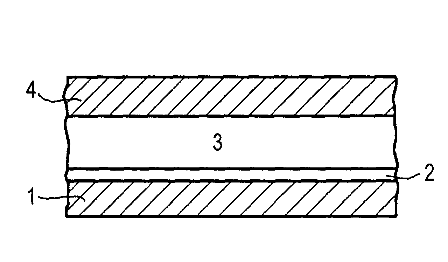

Im folgenden wird die vorliegende Erfindung anhand eines in der Zeichnung dargestellten Ausführungsbeispiels näher erläutert.

In der Zeichnung ist ein Speicherkondensator dargestellt, der beispielsweise als Teil eines nicht dargestellten Halbleiterspeicher-Bauelements hergestellt werden kann. In diesem Speicherbauelement ist der Speicherkondensator von dem Auswahltransistor durch eine Isolationsschicht getrennt und entweder direkt oberhalb ("stacked cell") oder versetzt oberhalb ("offset cell") des Auswahltransistors angeordnet. Eine erste Elektrodenschicht 1 des Speicherkondensators, die beispielsweise aus Platin bestehen kann, wird auf der Isolationsschicht aufgebracht.

Dann wird beispielsweise mit CVD eine sehr dünne, z.B. 1 nm dicke, CeO₂-Schicht 2 abgeschieden. Da die CeO₂-Schicht 2 sehr dünn ist, wird durch sie das elektrische Verhalten des herzustellenden Kondensators angesichts der wesentlich dickeren SBT-Schicht im wesentlichen nicht beeinflußt. Andererseits kann diese Schicht wesentlich dazu beitragen, die Kristallisationstemperatur des SBT deutlich zu senken.

Auf die CeO₂-Schicht 2 wird dann eine SrBi₂Ta₂O₉-(SBT-) oder SrBi₂(Ta, Nb)₂O₉-(SBTN-)Schicht 3 beispielsweise durch ein Sputter-Verfahren mit einer Dicke von z.B. 20-200 nm, abgeschieden. Diese Schicht soll als das Dielektrikums des Speicherkondensators verwendet werden. Nach der Abscheidung liegt die Schicht 3 im amorphen Zustand vor und muß zunächst kristallisiert werden. Daher wird nach der Abscheidung eine Temperaturbehandlung bei einer Temperatur vorzugsweise im Bereich zwischen 590°C und 620°C und einer Zeitdauer von einigen Minuten bis zu mehreren Stunden durchgeführt, um die in abgeschiedenem Zustand amorphe Schicht mindestens teilweise zu kristallisieren, d.h. in eine polykristalline Schicht umzuwandeln.

Anschließend wird zur Vervollständigung des Speicherkondensators eine zweite Elektrodenschicht 4 auf die kristallisierte Dielektrikumsschicht 3 aufgebracht.

Durch die Erfindung kann insbesondere die Herstellung eines Speicherkondensators nach dem "stacked cell"-Konzept erleichtert werden, da ein Metallisierungsstopfen, mit dem die erste Elektrodenschicht 1 mit dem Drain des Auswahltransistors verbunden ist, nur noch einer Maximaltemperatur im Bereich zwischen 590°C und 620°C ausgesetzt ist. Die Absenkung der Prozeßtemperatur für die Kristallisierung der ferroelektrischen Schicht kommt aber unter Umständen auch anderen bereits vorhandenen Bauelementabschnitten zugute.

## Patentansprüche

1. Verfahren zum Herstellen eines Speicherkondensators, dessen Dielektrikum aus einer ferroelektrischen Schicht auf der Basis von Strontium-Wismut-Tantalat aufgebaut ist, mit den Schritten:
- Bereitstellen einer ersten Elektrodenschicht (1) ;
- Aufbringen einer CeO₂-Schicht (2) auf der ersten Elektrodenschicht (1), die eine Dicke von < 5 nm, insbesondere ca. 1 nm, aufweist;
- Aufbringen einer im wesentlichen amorphen Dielektrikumsschicht (3), welche SrBi₂Ta₂O₉ (SBT) oder SrBi₂(Ta, Nb)₂O₉ (SBTN) enthält oder daraus besteht, auf die CeO₂-Schicht (2);
- Durchführen einer Temperaturbehandlung zum Kristallisieren der Dielektrikumsschicht (3) im Bereich zwischen 590°C und 620°C; und
- Aufbringen einer zweiten Elektrodenschicht (4) auf die Dielektrikumsschicht (3).

2. Verfahren zur Herstellung eines Halbleiterbauelements, bei welchem
- auf einem Halbleitersubstrat ein Schalttransistor geformt wird, und
- auf dem Schalttransistor ein Speicherkondensator gemäß dem Verfahren nach Anspruch 1 geformt wird.

3. Verfahren nach einem der Ansprüche 1 oder 2,
**dadurch gekennzeichnet,** daß
- die Elektrodenschichten (2, 4) aus einem Platinmetall, insbesondere Platin, einem leitfähigen Oxid eines Platinmetalls oder einem anderen inerten und leitfähigen Oxid hergestellt werden.

4. Verfahren nach einem der Ansprüche 1 bis 3,
**dadurch gekennzeichnet,** daß
- die Dielektrikumsschicht (3) eine Dicke von 20-200 nm aufweist.
